# EUROPEAN PATENT SPECIFICATION

(11) **EP 3 620 679 B1**
(45) Date of publication and mention of the grant of the patent: **04.08.2021**
(21) Application number: 19182899.5
(22) Date of filing: 27.06.2019
(51) Int. Cl.: F16F 1/38, F16F 1/387

(54) **VARIABLE STIFFNESS SPHERICAL HINGE AND VARIABLE STIFFNESS DESIGN METHOD THEREFOR**
KUGELGELENK MIT VARIABLER STEIFIGKEIT UND AUSLEGUNGSVERFAHREN EINES SOLCHEN KUGELGELENKS
CHARNIÈRE SPHÉRIQUE À RIGIDITÉ VARIABLE ET MÉTHODE DE CONCEPTION D'UNE TELLE CHARNIÈRE SPHÉRIQUE

(30) Priority: 23.08.2018 CN 201810965078
(43) Date of publication of application: 11.03.2020
(73) Proprietor: Zhuzhou Times New Material Technology Co., Ltd., Zhuzhou, Hunan 412007 (CN)
(72) Inventor: Sun, Haiyan, Zhuzhou, Hunan, 412007 (CN); Tan, Fang, Zhuzhou, Hunan, 412007 (CN); FENG, Wansheng, Zhuzhou, Hunan, 412007 (CN); RONG, Jigang, Zhuzhou, Hunan, 412007 (CN); LIN, Sheng, Zhuzhou, Hunan, 412007 (CN); Yan, Yao, Zhuzhou, Hunan, 412007 (CN); Lan, Jiabiao, Zhuzhou, Hunan, 412007 (CN); Li, Gang, Zhuzhou, Hunan, 412007 (CN); Yang, Zhe, Zhuzhou, Hunan, 412007 (CN); Li, Dongge, Zhuzhou, Hunan, 412007 (CN)
(74) Representative: Keil & Schaafhausen Patentanwälte PartGmbB

(56) References cited:
- EP-A2- 0 044 908
- CN-A- 101 368 609
- CN-A- 101 705 977
- CN-A- 106 090 091
- US-A- 4 032 202
- US-A- 4 790 520
- US-A- 5 725 202
- US-A1- 2017 097 061

## Description

### Technical Field

The present invention relates to a variable stiffness spherical hinge and a variable stiffness design method therefor, and belongs to the field of spherical hinge design.

### Background

During the operation of a spherical hinge product installed on a vehicle, vibration reduction, traction and flexible connection can be realized according to different installation positions and designed functions. In order to ensure the comfort of vehicle operation, it is required that the spherical hinge product has a relatively small stiffness under a small load (during normal operation); in order to ensure the reliability of vehicle operation, it is required that the product has a significantly increased stiffness under a large load (during starting and braking), thereby being limited in time; therefore the spherical hinge product is required to have a certain degree of variable stiffness.

Since rubber is easily torn under a tensile load, the radial deformation of a spherical hinge must be controlled within a certain range, otherwise rubber tensile damage is easily caused. In order to prevent this phenomenon from occurring, the product needs to be pre-compressed after vulcanization to keep the rubber in a compressed state. The pre-compression amount of the product is designed according to the maximum deformation amount of the product during use, so that the occurrence of rubber tensile damage can be effectively avoided.

In the existing spherical hinge products, rubber full through holes are used to meet the requirements of large variable stiffness, whereas common structures without holes are used for small variable stiffness. However, spherical hinges of a structure with holes are greatly deformed under load, and the use of a fully-through hollow or solid structure tends to cause a serious "buckling" phenomenon to a product at the intersection of rubber profiles after pre-compression and under load; the larger the pre-compression amount or load is, the more serious the "buckling" phenomenon is. Therefore, the increase in pre-compression amount of the product is limited, making the rubber easy to be in a stretched state in loading process and then have cracks. In addition, a structure with external holes is easy to cause external dust, dirt and even sand particles to enter the spherical hinges. External dust, dirt and even sand entering the spherical hinges will not only cause the hollow space to become smaller, the stiffness of the product to enter a nonlinear stage early, but also cause rubber corrosion and splitting. In a spherical hinge of a structure with holes, due to the limited space of the rubber, the larger the pre-compression amount or load is, the more serious the "buckling" phenomenon is, so it is unable to achieve the purpose of small stiffness in early stage and large stiffness in later stage, and the fatigue performance is poor.

Relevant prior art retrieved:
CN 108035999 A, a nonlinear variable stiffness adjustment method for traction spherical hinge and a traction spherical hinge, which adjusts the nonlinear variable stiffness of a rail transit traction spherical hinge by adjusting the position relationship between a metal part and a rubber part of the rail transit traction spherical hinge, and is characterized in that: the nonlinear variable stiffness adjustment of the rail transit traction spherical hinge includes radial variable stiffness adjustment and axial variable stiffness adjustment of the rail transit traction spherical hinge, and the nonlinear variable stiffness of the whole rail transit traction spherical hinge is realized by the radial variable stiffness adjustment and the axial variable stiffness adjustment of the rail transit traction spherical hinge.

CN 107269749A, a traction rubber spherical hinge, comprising a mandrel, a sleeve and a rubber layer vulcanized and bonded between the mandrel and the sleeve, and characterized in that: the rubber outer profile of the rubber layer is composed of an end surface I close to the sleeve and an end surface II close to the mandrel; the end surface I is in an outwardly convex shape which gradually approaches the sleeve from outside to inside, and is composed of a plurality of annular surfaces connected in sequence; the end surface II is an annular plane and smoothly transits to the end surface I by a fillet; and the end surface I is transitionally connected with the inner wall of the sleeve through a small fillet.

CN 101852263 A, a spherical hinge type rubber elastic element variable stiffness method as well as a rubber elastic element and a manufacturing method therefor, which adopt a step of symmetrically removing part of rubber material, and provide different stiffnesses through a contact surface and a rubber deformation limitation degree in different stress stages to achieve variable stiffnesses. The step of symmetrically removing part of rubber material is to hollow out 3-5 annular spaces in the surface of a rubber elastic body along circumferential direction, so that after the rubber elastic body is assembled with an outer metal sleeve, the outer metal sleeve is only in partial contact with the rubber elastic body in an idle state, 3-5 annular air isolation zones are formed, and the spaces for rubber bulging at both ends are very small; at the same time, after the rubber elastic body is assembled with the outer metal sleeve, an annular gap belt is also left between the rubber elastic body and the inner side surface of the outer metal sleeve.

CN 106090091 A discloses a metal rubber joint radial limiting method. Two metal rubber joints, an inner cylinder and an outer cylinder at the periphery of the inner cylinder are provided. The metal rubber joint radial limiting method is characterized in that the two metal rubber joints are axially aligned and are respectively mounted between the inner cylinder and the outer cylinder in a pressed manner; an annular stopper coaxial with the metal rubber joints is arranged between the two metal rubber joints; and through the annular stopper, radial limiting of the metal rubber joints is realized. With the adoption of the metal rubber joint radial limiting method, the uniformity of radial stiffness of the metal rubber joints can be ensured effectively, and the reliability of the radial limiting of the metal rubber joints is improved. The invention further provides a metal rubber joint component.

US 4032202 A discloses a bush assembly for vibration control, particularly adapted for use in supporting a suspension arm of an automobile suspension system. The bush assembly includes an inner sleeve which is stationarily supported, and an outer sleeve coaxially encircling the inner sleeve and defining a cylindrical clearance space encircling the inner sleeve. The inner and outer sleeves are both separable into a pair of sleeve sections which meet end to end substantially in a common plane. The clearance space is partly filled with a pair of generally cylindrical, primary impact absorbing members which contact the inner and outer sleeves and are disposed symmetrically with respect to the plane in which the inner and outer sleeves are separable into their respective sections.

CN101368609A discloses a spherical hinge class rubber elastic element rigidity varying method and a spherical hinge class rubber elastic element. A combination mode of the multi-segment spherical hinge class rubber elastic bodies is adopted. The non-linear properties of the segments of the spherical hinge rubber elastic bodies are different. The spherical hinge class rubber elastic elements with different non-linear properties are combined on a spindle to realize the variation of the rigidity of the whole spherical hinge class rubber elastic element in different situations and radial directions, so as to realize the varying rigidity purpose. The spherical hinge class rubber elastic element comprises a metal spindle, a metal outer sleeve, an elastic rubber body and a metal inner sleeve. The elastic rubber body, the metal outer sleeve and the metal inner sleeve are integrated to a whole through vulcanization. The metal inner sleeve is nested on the metal spindle. The spherical hinge class rubber elastic element rigidity varying method and the spherical hinge class rubber elastic element have the advantages that the spherical hinge class rubber elastic element is the combined structure of a mutually-independent three-segment elastic body. The whole spherical hinge class rubber elastic rubber is composed of three independent parts, including a metal outer sleeve, an elastic rubber body, a metal inner sleeve; the elastic bodies are axially combined on the spindle to construct a whole.

For the existing patents mentioned above, there is still room for improvement in the aspect of meeting the loading requirement that the spherical hinge product has a small stiffness under a small load (during normal operation) and a significantly increased stiffness under a large load (during starting and braking) and can be limited in time, and in the aspects of fatigue life and reliability.

### Summary

A variable stiffness spherical hinge and a variable stiffness design method therefor provided by the present invention meet the loading requirement that the spherical hinge needs a small stiffness under a small load and a significantly increased stiffness under a large load and can be limited in time. The present invention can effectively prevent external dust, dirt and even sand particles from entering the spherical hinge, which increases the release space of the rubber, effectively avoids the "buckling" deformation of the rubber, and is favorable for increasing the pre-compression amount of the product, preventing the occurrence of rubber cracks and improving the fatigue life.

To achieve the above purpose, the present invention adopts the following technical solution: A variable stiffness spherical hinge, comprising a spherical hinge main body and an outer layer sleeve sheathed on the spherical hinge main body, and characterized in that: an annular sealed space is formed between the spherical hinge main body and the outer layer sleeve along circumferential direction, and the annular sealed space extends deep into a rubber layer of the spherical hinge main body; an annular stop is arranged in the annular sealed space, and the annular sealed space is not fully filled by the annular stop; an annular gap is formed between the spherical hinge main body and the annular stop along axial direction, and the minimum radial width of the annular gap is X, with 0.5 mm<X< 10 mm.

The spherical hinge main body comprises a mandrel, a rubber layer and an inner layer sleeve which are vulcanized and bonded in sequence from inside to outside, and the annular sealed space extends from the inner layer sleeve deep into the rubber layer along radial direction.

Preferably, the bottom surface of the annular sealed space is parallel to the bottom surface of the annular stop, the radial spacing between the two is X, and the spacing between the side wall of the annular stop and the side wall of the annular sealed space is less than X.

Preferably, the annular stop is in axial location fit with the spherical hinge main body, the spherical hinge main body is in interference fit with the outer layer sleeve, and the outer diameter of the annular stop is equal to that of the spherical hinge main body.

The inner layer sleeve is composed of two annular metal sleeves which are arranged symmetrically, the rubber layer has an annular notch in circumferential direction, the annular metal sleeves are arranged on the left and right sides of the annular notch, the outer layer sleeve is sheathed on the annular metal sleeves to seal the annular notch and form the annular sealed space, an inner layer annular step A is formed between the edges of the inner end of each annular metal sleeve and the outer end of the annular notch, and the edges of both ends of the annular stop are the step-shape edges corresponding to the inner layer annular step A.

The edges of the inner ends of the annular metal sleeves are in a step shape and form an outer layer annular step B connected with the inner layer annular step A, and the edges of both ends of the annular stop are the double-step-shape edges corresponding to the inner layer annular step A and the outer layer annular step B.

Preferably, the bottom wall of the annular notch is an axial plane, the side wall is an annular cambered surface, and the cross section of the part of the annular stop extending into the annular notch is a trapezoid with the width gradually reduced from outside to inside.

Preferably, the annular stop is in a multi-lobed composite structure.

A variable stiffness design method for the variable stiffness spherical hinge mentioned above, characterized in that the stiffness variation of the variable stiffness spherical hinge in radial loading process is adjusted by adjusting the shape and size of the annular sealed space and the annular stop, and the variable stiffness inflexion point of the variable stiffness spherical hinge in radial loading process is adjusted by adjusting the size of the annular gap.

Preferably, "the variable stiffness inflexion point of the variable stiffness spherical hinge in radial loading process is adjusted by adjusting the size of the annular gap" specifically means that the position of the variable stiffness inflexion point is adjusted by adjusting the minimum radial width X of the annular gap, and the stiffness value of the variable stiffness inflexion point is adjusted by adjusting the thickness D of the rubber layer between the annular gap and the inner layer sleeve.

The present invention has the following beneficial effects:
1. The annular stop is arranged in the annular sealed space; when the load is small, the volume of the annular gap is gradually reduced, and the stiffness is linearly increased; when the load is further increased, the minimum radial width of the annular gap is reduced to zero, the stiffness is instantly increased, and the variable stiffness inflexion point is formed; when the increase of the load continues, the stiffness is further increased until the annular stop comes into hard contact with the spherical hinge main body, and the radial deformation of the spherical hinge main body is limited, thereby meeting the loading requirement that the spherical hinge needs a small stiffness under a small load and a significantly increased stiffness under a large load and can be limited in time.
2. The arrangement of the annular sealed space increases the flowing space when the rubber deforms, which can effectively prevent the buckling of a rubber profile at the end part of the spherical hinge main body during pre-compression or loading; the pre-compression amount design of the product is no longer limited by the rubber profile and the release space, which can greatly increase the pre-compression amount according to actual needs and reduce the tensile damage of the rubber, thereby increasing the fatigue life.
3. In radial loading process, the rubber first flows to the annular gap, fills the annular gap, and bulges from both end profiles of the rubber through extrusion of the rubber by the annular stop, which protects the state variation of bulging outward of the rubber profile at the end part of the spherical hinge in loading process, thereby preventing the folding of the rubber profile at the end part; in deformation process, the rubber first flows to fill the annular gap, and then bulges from both ends to reduce the radial extrusion speed of the rubber, thereby improving the vibration reduction effect of the spherical hinge.
4. The stop is sealed in the spherical hinge, which can effectively prevent external dust, dirt and even sand particles from entering the spherical hinge; in addition, the appearance and shape are firmer and more reliable, the service life of the spherical hinge is longer, and the service reliability and appearance acceptability are better.
5. The annular stop is in axial location fit with the annular sealed space, which can guarantee the location reliability of the annular stop in the annular sealed space in loading process, therefore the structure stability and reliability of the spherical hinge are higher.

### Description of Drawings

Fig. 1 is a structural schematic diagram of a variable stiffness spherical hinge in the detailed description.
Fig. 2 is a structural schematic diagram of a spherical hinge main body.
Fig. 3 is a structural schematic diagram of an assembly of a spherical hinge main body and an outer layer sleeve.
Fig. 4 is a stiffness variation diagram of a variable stiffness spherical hinge in radial loading process.

### Detailed Description

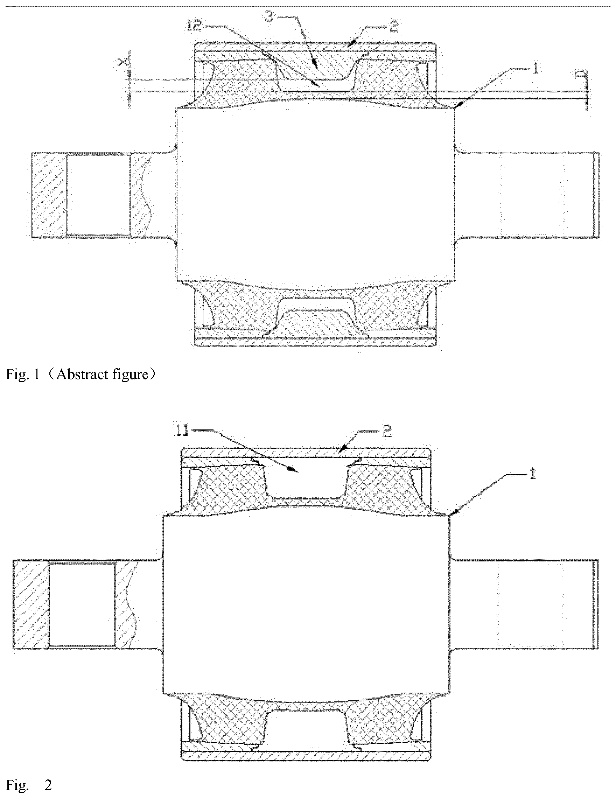

Embodiment of the present invention is described in details below in combination with Fig. 1 to Fig. 4.

A variable stiffness spherical hinge, comprising a spherical hinge main body 1 and an outer layer sleeve 2 sheathed on the spherical hinge main body 1, and characterized in that: an annular sealed space 11 is formed between the spherical hinge main body 1 and the outer layer sleeve 2 along circumferential direction, and the annular sealed space 11 extends deep into a rubber layer of the spherical hinge main body 1; an annular stop 3 is arranged in the annular sealed space 11, and the annular sealed space 11 is not fully filled by the annular stop 3; an annular gap 12 is formed between the spherical hinge main body 1 and the annular stop 3 along axial direction, and the minimum radial width of the annular gap 12 is X, with 0.5 mm<X< 10 mm.

As shown in Fig. 1, the annular sealed space is arranged between the spherical hinge main body 1 and the outer layer sleeve 2, the annular stop 3 is located in the annular sealed space, and the annular gap 12 is formed between the annular stop 3 and the spherical hinge main body 1; since the annular sealed space extends deep into the rubber layer of the spherical hinge main body 1, the surfaces opposite to the annular stop 3 are all rubber surfaces; in the case that the radial load is small, rubber deforms and flows to the annular sealed space to fully fill the spaces on both sides of the annular stop 3 first, making the stiffness of the spherical hinge linearly increased; with the further increase of the radial load, when the bottom surface of the annular stop 3 comes into contact with a rubber profile, the stiffness of the spherical hinge will be instantly increased, and a variable stiffness inflexion point will be formed; when the radial load is further increased, the stiffness is further increased through extrusion of the rubber layer by the annular stop 3, making the stiffness vary nonlinearly; when the annular stop 3 comes into hard contact with the spherical hinge main body 1, the stiffness is increased to the maximum, and the radial deformation of the spherical hinge is limited in time; the present invention can meet the loading requirement that the spherical hinge needs a small stiffness under a small load and a significantly increased stiffness under a large load and can be limited in time. The arrangement of the annular sealed space increases the flowing space when the rubber deforms, and can effectively prevent the buckling of a rubber profile at the end part of the spherical hinge main body during pre-compression or loading, which can not only protect the state variation of bulging outward of the rubber profile at the end part of the spherical hinge in loading process, thereby preventing the folding of the rubber profile at the end part, but also greatly increase the pre-compression amount according to actual needs and reduce the tensile damage of the rubber in loading process, thereby increasing the fatigue life of the spherical hinge. In deformation process, the rubber first flows to fill the annular gap, and then bulges from both ends to reduce the radial extrusion speed of the rubber, thereby improving the vibration reduction effect of the spherical hinge.

The spherical hinge main body 1 comprises a mandrel 13, a rubber layer 14 and an inner layer sleeve 15 which are vulcanized and bonded in sequence from inside to outside, and the annular sealed space 11 extends from the inner layer sleeve 15 deep into the rubber layer 14 along radial direction. The bottom surface of the annular sealed space 11 is parallel to the bottom surface of the annular stop 3, the radial spacing between the two is X, and the spacing between the side wall of the annular stop 3 and the side wall of the annular sealed space 11 is less than X. When the load is small, the side wall of the annular stop 3 comes into contact with the side wall of the annular sealed space 11 first, the contact area is enlarged, and the stiffness is gradually increased, that is to say, the rubber deforms and flows to the spaces on both sides of the annular stop to fully fill the spaces first, and then the annular stop gradually approaches the bottom surface of the annular sealed space 11 until X is reduced to zero; the bottom surface of the annular sealed space 11 comes into contact with the bottom surface of the annular stop 3, and the variable stiffness inflexion point is formed.

The annular stop 3 is in axial location fit with the spherical hinge main body 1, which guarantees that in loading process, the annular stop 3 has no axial movement relative to the spherical hinge main body 1, the annular stop 3 only limits the radial loading deformation of the spherical hinge without exerting an axial force on the spherical hinge, the spherical hinge main body 1 is in interference fit with the outer layer sleeve 2, the outer diameter of the annular stop 3 is equal to that of the spherical hinge main body 1, and the outer layer sleeve 2 is in interference fit with the annular stop 3 to press the annular stop 3 tightly against the spherical hinge main body 1.

The inner layer sleeve 15 is composed of two annular metal sleeves 15.1 which are arranged symmetrically, the rubber layer 14 has an annular notch 14.1 in circumferential direction, the annular metal sleeves 15.1 are arranged on the left and right sides of the annular notch 14.1, the outer layer sleeve 2 is sheathed on the annular metal sleeves 15.1 to seal the annular notch 14.1 and form the annular sealed space 1, an inner layer annular step A is formed between the edges of the inner end of each annular metal sleeve 15.1 and the outer end of the annular notch 14.1, and the edges of both ends of the annular stop 3 are the step-shape edges corresponding to the inner layer annular step A.

The edges of the inner ends of the annular metal sleeves 15.1 are in a step shape and form an outer layer annular step B connected with the inner layer annular step A, and the edges of both ends of the annular stop 3 are the double-step-shape edges corresponding to the inner layer annular step A and the outer layer annular step B.

It can be seen from the figures that double-step-shape edges are formed on the spherical hinge main body 1 in location fit with the annular stop 3, and are used for the axial location of the annular stop 3; the inner layer annular step A is located between the rubber layer 14 and the inner layer sleeve 15, and the outer layer annular step B is located on the inner layer sleeve 15; the double-step fitted location structure guarantees that in loading process, the annular stop 3 has no axial movement relative to the spherical hinge main body 1 and does not interfere with the axial deformation of the rubber layer.

The bottom wall of the annular notch 14.1 is an axial plane, the side wall is an annular cambered surface, and the cross section of the part of the annular stop 3 extending into the annular notch 14.1 is a trapezoid with the width gradually reduced from outside to inside. The cambered surface design of the annular notch 14.1 is favorable for gradually fitting the side wall of the annular stop 3 when the rubber bulges, and guarantees that the stiffness is linearly and synchronously increased when the load is small.

The annular stop 3 is in a multi-lobed composite structure. During assembly, the annular stop 3 is assembled on the spherical hinge main body 1 first, the annular stop 3 and the spherical hinge main body are axially located through the double-step location structure and then pressed into the outer layer sleeve 2; since the outer layer sleeve 2 is in interference fit with the spherical hinge main body 1, the rubber layer 14 can be pre-compressed; at the same time, the outer layer sleeve 2 is in interference fit with the annular stop 3 to press the annular stop 3 tightly against the spherical hinge main body 1. If the pre-compression amount of the rubber layer 14 needs to be increased, it only needs to perform radial extrusion on the assembled spherical hinge to reduce the space volume of the annular gap and make the rubber layer 14 further compressed.

A variable stiffness design method for the variable stiffness spherical hinge mentioned above, characterized in that the stiffness variation of the variable stiffness spherical hinge in radial loading process is adjusted by adjusting the shape and size of the annular sealed space 11 and the annular stop 3, and the variable stiffness inflexion point of the variable stiffness spherical hinge in radial loading process is adjusted by adjusting the size of the annular gap 12.

"The variable stiffness inflexion point of the variable stiffness spherical hinge in radial loading process is adjusted by adjusting the size of the annular gap 12" specifically means that the position of the variable stiffness inflexion point is adjusted by adjusting the minimum radial width X of the annular gap 12, and the stiffness value of the variable stiffness inflexion point is adjusted by adjusting the thickness D of the rubber layer between the annular gap 12 and the inner layer sleeve 15.

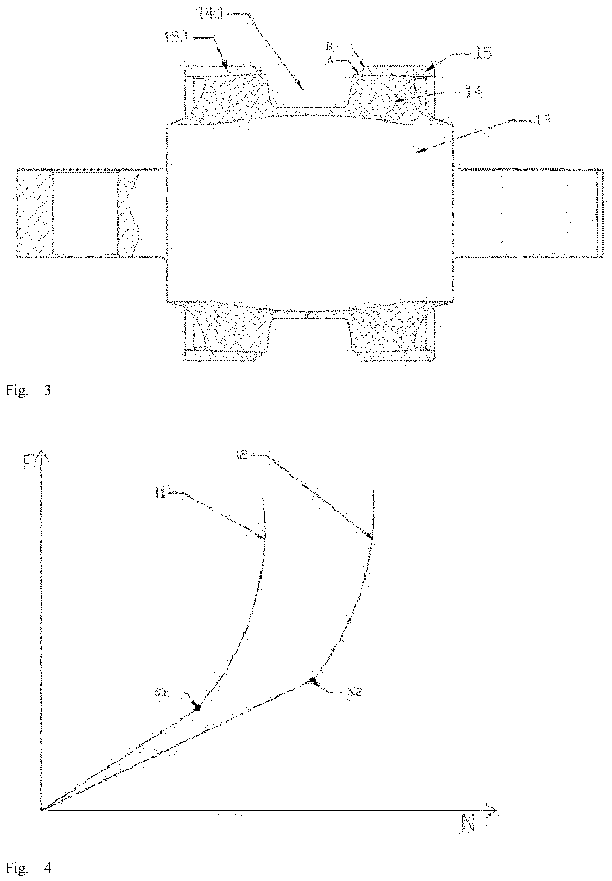

As shown in Fig. 4, there are two stiffness variation curves; in the radial loading process of the variable stiffness spherical hinge, in the case that the radial load is small, rubber deforms and flows to the annular sealed space to fully fill the spaces on both sides of the annular stop 3 first, making the stiffness of the spherical hinge linearly increased; with the further increase of the radial load, when the bottom surface of the annular stop 3 comes into contact with a rubber profile, the stiffness of the spherical hinge will be instantly increased, and a variable stiffness inflexion point, i.e., a variable stiffness inflexion point S1 in a stiffness variation curve L1 or a variable stiffness inflexion point S2 in a stiffness variation curve L2, will be formed; when the increase of the radial load continues, the stiffness is further increased through extrusion of the rubber layer by the annular stop 3, making the stiffness vary nonlinearly; when the annular stop 3 comes into hard contact with the spherical hinge main body 1, the stiffness is increased to the maximum, and the radial deformation of the spherical hinge is limited in time; the present invention can meet the loading requirement that the spherical hinge needs a small stiffness under a small load and a significantly increased stiffness under a large load and can be limited in time. The stiffness variation of the variable stiffness spherical hinge in radial loading process is adjusted by adjusting the shape and size of the annular sealed space 11 and the annular stop 3, for example, the stiffness variation curve of the spherical hinge in loading process can be adjusted from L1 to L2; the slope of line in linear variation process and the slope of curve in curve variation process of the stiffness are adjusted to meet the stiffness variation requirements in different operating conditions. The variable stiffness inflexion point of the variable stiffness spherical hinge in radial loading process is adjusted by adjusting the size of the annular gap 12, wherein the position of the variable stiffness inflexion point is adjusted by adjusting the minimum radial width X of the annular gap 12, i.e., adjusting the position of the variable stiffness inflexion point in the stiffness variation curve of the spherical hinge; the stiffness value of the variable stiffness inflexion point is adjusted by adjusting the thickness D of the rubber layer between the annular gap 12 and the inner layer sleeve 15, i.e., adjusting the stiffness value of the spherical hinge when the variable stiffness inflexion point appears; the stiffness values corresponding to the variable stiffness inflexion point S1 in the stiffness variation curve L1 and the variable stiffness inflexion point S2 in the stiffness variation curve L2 shown in Fig. 4 are different.

The technical solution of the embodiment of the present invention is fully described above in combination with the drawings. It should be noted that the described embodiment is merely part of the embodiments of the present invention. Based on the embodiment in the present invention, all other embodiments obtained by those ordinary skilled in the art without contributing creative labor will belong to the protection scope of the present invention, which is defined by the appended claims.

## Claims

1. A variable stiffness spherical hinge, comprising a spherical hinge main body (1) and an outer layer sleeve (2) sheathed on the spherical hinge main body (1), wherein: an annular sealed space (11) is formed between the spherical hinge main body (1) and the outer layer sleeve (2) along the circumferential direction, and the annular sealed space (11) extends deep into a rubber layer of the spherical hinge main body (1); an annular stop (3) is arranged in the annular sealed space (11), and the annular sealed space (11) is not fully filled by the annular stop (3); an annular gap (12) is formed between the spherical hinge main body (1) and the annular stop (3) along the axial direction, and the minimum radial width of the annular gap (12) is X, with 0.5 mm<X<10 mm, and wherein the spherical hinge main body (1) comprises a mandrel (13), a rubber layer (14) and an inner layer sleeve (15) which are vulcanized and bonded in sequence from inside to outside, and the annular sealed space (11) extends from the inner layer sleeve (15) deep into the rubber layer (14) along radial direction,
**characterized in that** the inner layer sleeve (15) is composed of two annular metal sleeves (15.1) which are arranged symmetrically, the rubber layer (14) has an annular notch (14.1) in circumferential direction, the annular metal sleeves (15.1) are arranged on the left and right sides of the annular notch (14.1), the outer layer sleeve (2) is sheathed on the annular metal sleeves (15.1) to seal the annular notch (14.1) and form the annular sealed space (11), an inner layer annular step (A) is formed between the edges of the inner end of each annular metal sleeve (15.1) and the outer end of the annular notch (14.1), and the edges of both ends of the annular stop (3) are step-shape edges corresponding to the inner layer annular step (A), and the edges of the inner ends of the annular metal sleeves (15.1) are in a step shape and form an outer layer annular step (B) connected with the inner layer annular step (A), and the edges of both ends of the annular stop (3) are a double-step-shape edges corresponding to the inner layer annular step (A) and the outer layer annular step (B).

2. The variable stiffness spherical hinge according to claim 1, **characterized in that**: the bottom surface of the annular sealed space (11) is parallel to the bottom surface of the annular stop (3), the radial spacing between the two is X, and the spacing between the side wall of the annular stop (3) and the side wall of the annular sealed space (11) is less than X.

3. The variable stiffness spherical hinge according to claim 1, **characterized in that**: the annular stop (3) is in axial location fit with the spherical hinge main body (1), the spherical hinge main body (1) is in interference fit with the outer layer sleeve (2), and the outer diameter of the annular stop (3) is equal to that of the spherical hinge main body (1).

4. The variable stiffness spherical hinge according to claim 1, **characterized in that** said double-step-shape edges are formed on the spherical hinge main body (1) in location fit with the annular stop (3), and are used for the axial location of the annular stop (3), the inner layer annular step (A) is located between the rubber layer (14) and the inner layer sleeve (15), and the outer layer annular step (B) is located on the inner layer sleeve (15); the double-step fitted location structure guarantees that in loading process, the annular stop (3) has no axial movement relative to the spherical hinge main body (1) and does not interfere with the axial deformation of the rubber layer.

5. The variable stiffness spherical hinge according to claim 1, **characterized in that**: the bottom wall of the annular notch (14.1) is an axial plane, the side wall is an annular cambered surface, and the cross section of the part of the annular stop (3) extending into the annular notch (14.1) is a trapezoid with the width gradually reduced from outside to inside.

6. The variable stiffness spherical hinge according to claim 1, **characterized in that**: the annular stop (3) is in a multi-lobed composite structure.

7. A variable stiffness design method for variable stiffness spherical hinge according to any one of claim 1 to 6, **characterized in that** the stiffness variation of the variable stiffness spherical hinge in radial loading process is adjusted by adjusting the shape and size of the annular sealed space (11) and the annular stop (3), and the variable stiffness inflexion point of the variable stiffness spherical hinge in radial loading process is adjusted by adjusting the size of the annular gap (12).

8. The variable stiffness design method according to claim 7, **characterized in that**: "the variable stiffness inflexion point of the variable stiffness spherical hinge in radial loading process is adjusted by adjusting the size of the annular gap (12)" specifically means that the position of the variable stiffness inflexion point is adjusted by adjusting the minimum radial width X of the annular gap (12), and the stiffness value of the variable stiffness inflexion point is adjusted by adjusting the thickness D of a rubber layer between the annular gap (12) and the inner layer sleeve (15).

## Patentansprüche

1. Sphärisches Scharnier mit variabler Steifigkeit, umfassend einen sphärischen Scharnierhauptkörper (1) und eine Außenschichthülse (2), die auf dem sphärischen Scharnierhauptkörper (1) ummantelt ist, wobei: ein ringförmiger abgedichteter Raum (11) zwischen dem sphärischen Scharnierhauptkörper (1) und der Außenschichthülse (2) entlang der Umfangsrichtung gebildet ist, und der ringförmige abgedichtete Raum (11) sich tief in eine Gummischicht des sphärischen Scharnierhauptkörpers (1) erstreckt; ein ringförmiger Anschlag (3) in dem ringförmigen abgedichteten Raum (11) angeordnet ist, und der ringförmige abgedichtete Raum (11) nicht vollständig durch den ringförmigen Anschlag (3) ausgefüllt ist; ein ringförmiger Spalt (12) zwischen dem sphärischen Scharnierhauptkörper (1) und dem ringförmigen Anschlag (3) entlang der axialen Richtung gebildet ist, und die minimale radiale Breite des ringförmigen Spalts (12) X, mit 0. 5 mm < X < 10 mm, beträgt, und wobei der sphärische Scharnierhauptkörper (1) einen Dorn (13), eine Gummischicht (14) und eine Innenschichthülse (15) aufweist, die nacheinander von innen nach außen vulkanisiert und verbunden sind, und der ringförmige abgedichtete Raum (11) sich von der Innenschichthülse (15) tief in die Gummischicht (14) entlang der radialen Richtung erstreckt, **dadurch gekennzeichnet, dass** die Innenschichthülse (15) aus zwei ringförmigen Metallhülsen (15.1) besteht, die symmetrisch angeordnet sind, die Gummischicht (14) eine ringförmige Kerbe (14.1) in Umfangsrichtung aufweist, die ringförmigen Metallhülsen (15.1) links und rechts der ringförmigen Kerbe (14. 1) angeordnet sind, die Außenschichthülse (2) auf den ringförmigen Metallhülsen (15.1) ummantelt ist, um die ringförmige Kerbe (14.1) abzudichten und den ringförmigen abgedichteten Raum (11) zu bilden, eine innere Schichtringstufe (A) zwischen den Kanten des inneren Endes jeder ringförmigen Metallhülse (15. 1) und dem äußeren Ende der ringförmigen Kerbe (14.1) gebildet ist, und die Kanten beider Enden des ringförmigen Anschlags (3) die stufenförmigen Kanten sind, die der ringförmigen Innenschichtstufe (A) entsprechen, und die Kanten der inneren Enden der ringförmigen Metallhülsen (15. 1) stufenförmig sind und eine ringförmige Außenschichtstufe (B) bilden, die mit der ringförmigen Innenschichtstufe (A) verbunden ist, und die Kanten beider Enden des ringförmigen Anschlags (3) doppelt stufenförmige Kanten sind, die der ringförmigen Innenschichtstufe (A) und der ringförmigen Außenschichtstufe (B) entsprechen.

2. Sphärisches Scharnier mit variabler Steifigkeit nach Anspruch 1, **dadurch gekennzeichnet, dass** die Bodenfläche des ringförmigen abgedichteten Raums (11) parallel zur Bodenfläche des ringförmigen Anschlags (3) ist, der radiale Abstand zwischen beiden X beträgt und der Abstand zwischen der Seitenwand des ringförmigen Anschlags (3) und der Seitenwand des ringförmigen abgedichteten Raums (11) kleiner als X ist.

3. Sphärisches Scharnier mit variabler Steifigkeit nach Anspruch 1, **dadurch gekennzeichnet, dass** der ringförmige Anschlag (3) in axialer Lagepassung mit dem sphärischen Scharnierhauptkörper (1) ist, der sphärische Scharnierhauptkörper (1) in Presspassung mit der Außenschichthülse (2) ist und der Außendurchmesser des ringförmigen Anschlags (3) gleich dem des sphärischen Scharnierhauptkörpers (1) ist.

4. Sphärisches Scharnier mit variabler Steifigkeit nach Anspruch 1, **dadurch gekennzeichnet, dass** die doppelt stufenförmige Kanten an dem sphärischen Scharnierhauptkörper (1) in Lagepassung mit dem ringförmigen Anschlag (3) ausgebildet sind und für die axiale Anordnung des ringförmigen Anschlags (3) verwendet werden, wobei die innere Schichtringstufe (A) zwischen der Gummischicht (14) und der Innenschichthülse (15) angeordnet ist und die ringförmige Außenschichtstufe (B) an der Innenschichthülse (15) angeordnet ist, wobei die zweistufig eingepasste Anordnungsstruktur gewährleistet, dass der ringförmige Anschlag (3) im Belastungsprozess keine axiale Bewegung relativ zum sphärischen Scharnierhauptkörper (1) hat und die axiale Verformung der Gummischicht nicht stört.

5. Sphärisches Scharnier mit variabler Steifigkeit nach Anspruch 1, **dadurch gekennzeichnet, dass** die Bodenwand der ringförmigen Kerbe (14.1) eine axiale Ebene ist, die Seitenwand eine ringförmig gewölbte Fläche ist, und der Querschnitt des Teils des ringförmigen Anschlags (3), der sich in die ringförmige Kerbe (14.1) hinein erstreckt, ein Trapez ist, dessen Breite sich von außen nach innen allmählich verringert.

6. Sphärisches Scharnier mit variabler Steifigkeit nach Anspruch 1, **dadurch gekennzeichnet, dass** der ringförmige Anschlag (3) in einer mehrlagigen Verbundstruktur vorliegt.

7. Verfahren zur Gestaltung eines Sphärischen Scharniers mit variabler Steifigkeit nach einem der Ansprüche 1 bis 6, **dadurch gekennzeichnet, dass** die Steifigkeitsvariation des sphärischen Scharniers mit variabler Steifigkeit im radialen Belastungsprozess durch Einstellen der Form und Größe des ringförmigen abgedichteten Raums (11) und des ringförmigen Anschlags (3) eingestellt wird, und dass der steifigkeitsvariable Knickpunkt des sphärischen Scharniers mit variabler Steifigkeit im radialen Belastungsprozess durch Einstellen der Größe des ringförmigen Spalts (12) eingestellt wird.

8. Verfahren zur Gestaltung eines Sphärischen Scharniers mit variabler Steifigkeit nach Anspruch 7, **dadurch gekennzeichnet, dass** "der steifigkeitsvariable Knickpunkt des sphärischen Scharniers mit variabler Steifigkeit im radialen Belastungsprozess durch Einstellen der Größe des ringförmigen Spalts (12) eingestellt wird" insbesondere bedeutet, dass die Lage des steifigkeitsvariablen Knickpunkts durch Einstellen der minimalen radialen Breite X des ringförmigen Spalts (12) eingestellt wird, und der Steifigkeitswert des steifigkeitsvariablen Knickpunkts durch Einstellen der Dicke D der Gummischicht zwischen dem ringförmigen Spalt (12) und der Innenschichthülse (15) eingestellt wird.

## Revendications

1. Charnière sphérique à rigidité variable comprenant un corps principal de charnière sphérique (1) et un manchon de couche extérieure (2) manchonné sur le corps principal de charnière sphérique (1), dans laquelle : un espace hermétique annulaire (11) est formé entre le corps principal de charnière sphérique (1) et le manchon de couche extérieure (2) le long de la direction circonférentielle, et l'espace hermétique annulaire (11) s'étend profondément dans une couche de caoutchouc du corps principal de charnière sphérique (1) ; une butée annulaire (3) est agencée dans l'espace hermétique annulaire (11), et l'espace hermétique annulaire (11) n'est pas complètement rempli par la butée annulaire (3) ; un écart annulaire (12) est formé entre le corps principal de charnière sphérique (1) et la butée annulaire (3) le long de la direction axiale, et la largeur radiale minimale de l'écart annulaire (12) est X, sachant que 0,5 mm<X<10 mm, et dans laquelle le corps principal de charnière sphérique (1) comprend un mandrin (13), une couche de caoutchouc (14) et un manchon de couche intérieure (15) qui sont vulcanisés et collés en séquence de l'intérieur vers l'extérieur, et l'espace hermétique annulaire (11) s'étend du manchon de couche intérieure (15) profondément jusque dans la couche de caoutchouc (14) le long de la direction radiale,
**caractérisée en ce que** le manchon de couche intérieure (15) est composé de deux manchons métalliques annulaires (15.1) qui sont agencés symétriquement, la couche de caoutchouc (14) présente une encoche annulaire (14.1) dans la direction circonférentielle, les manchons métalliques annulaires (15.1) sont agencés sur les côtés gauche et droit de l'encoche annulaire (14.1), le manchon de couche extérieure (2) est manchonné sur les manchons métalliques annulaires (15.1) pour fermer hermétiquement l'encoche annulaire (14.1) et former l'espace hermétique annulaire (11), un gradin annulaire de couche intérieure (A) est formé entre les bords de l'extrémité intérieure de chaque manchon métallique annulaire (15.1) et de l'extrémité extérieure de l'encoche annulaire (14.1), et les bords des deux extrémités de la butée annulaire (3) sont des bords en forme de gradin correspondant au gradin annulaire de couche intérieure (A) et les bords des extrémités intérieures des manchons métalliques annulaires (15.1) sont en forme de gradin et forment un gradin annulaire de couche extérieure (B) relié au gradin annulaire de couche intérieure (A) et les bords des deux extrémités de la butée annulaire (3) sont des bords en forme de double gradin correspondant au gradin annulaire de couche intérieure (A) et au gradin annulaire de couche extérieure (B).

2. Charnière sphérique à rigidité variable selon la revendication 1, **caractérisée en ce que** : la surface de fond de l'espace hermétique annulaire (11) est parallèle à la surface de fond de la butée annulaire (3), l'écartement radial entre les deux est X, et l'écartement entre la paroi latérale de la butée annulaire (3) et la paroi latérale de l'espace hermétique annulaire (11) est intérieur à X.

3. Charnière sphérique à rigidité variable selon la revendication 1, **caractérisée en ce que** : la butée annulaire (3) est en engagement par emplacement axial avec le corps principal de charnière sphérique (1), le corps principal de charnière sphérique (1) est en ajustement par interférence avec le manchon de couche extérieure (2), et le diamètre extérieur de la butée annulaire (3) est égal à celui du corps principal de charnière sphérique (1).

4. Charnière sphérique à rigidité variable selon la revendication 1, **caractérisée en ce que** lesdits bords en forme de double gradin sont formés sur le corps principal de charnière sphérique (1) en ajustement par emplacement avec la butée annulaire (3), et sont utilisés pour l'emplacement axial de la butée annulaire (3), le gradin annulaire de couche intérieure (A) est situé entre la couche de caoutchouc (14) et le manchon de couche intérieure (15), et le gradin annulaire de couche extérieure (B) est situé sur le manchon de couche intérieure (15) ; la structure d'emplacement logé à double gradin garantit que dans le processus de chargement, la butée annulaire (3) n'a pas de mouvement axial par rapport au corps principal de charnière sphérique (1) et n'interfère pas avec la déformation axiale de la couche de caoutchouc.

5. Charnière sphérique à rigidité variable selon la revendication 1, **caractérisée en ce que** : la paroi de fond de l'encoche annulaire (14.1) est un plan axial, la paroi latérale est une surface cambrée annulaire, et la section transversale de la partie de la butée annulaire (3) s'étendant jusque dans l'encoche annulaire (14.1) est un trapézoïde avec la largeur graduellement réduite de l'extérieur vers l'intérieur.

6. Charnière sphérique à rigidité variable selon la revendication 1, **caractérisée en ce que** : la butée annulaire (3) est une structure composite multi-lobée.

7. Procédé de conception de rigidité variable pour une charnière sphérique à rigidité variable selon l'une quelconque des revendications 1 à 6, **caractérisé en ce que** la variation de rigidité de la charnière sphérique à rigidité variable dans le processus de chargement radial est ajustée en ajustant la forme et la taille de l'espace hermétique annulaire (11) et de la butée annulaire (3), et le point d'inflexion de rigidité variable de la charnière sphérique à rigidité variable dans le processus de chargement radial est ajusté en ajustant la taille de l'écart annulaire (12).

8. Procédé de conception de rigidité variable selon la revendication 7, **caractérisé en ce que** : « le point d'inflexion de rigidité variable de la charnière sphérique à rigidité variable dans le processus de chargement radial est ajusté en ajustant la taille de l'écart annulaire (12) » signifie spécifiquement que la position du point d'inflexion de rigidité variable est ajustée en ajustant la largeur radiale minimale X de l'espace annulaire (12), et la valeur de rigidité du point d'inflexion de rigidité variable est ajustée en ajustant l'épaisseur D de la couche de caoutchouc entre l'écart annulaire (12) et le manchon de couche intérieure (15).
